(19) **Europäisches Patentamt / European Patent Office / Office européen des brevets**

(11) **EP 2 275 392 A1**

(12) # EUROPEAN PATENT APPLICATION
published in accordance with Art. 153(4) EPC

(43) Date of publication:
**19.01.2011 Bulletin 2011/03**

(51) Int Cl.:
***C04B 35/00*** (2006.01)  ***H01L 35/22*** (2006.01)
***H01L 35/34*** (2006.01)

(21) Application number: **09729870.7**

(22) Date of filing: **08.04.2009**

(86) International application number:
**PCT/JP2009/057543**

(87) International publication number:
**WO 2009/125871 (15.10.2009 Gazette 2009/42)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **10.04.2008 JP 2008102177**

(71) Applicant: **Sumitomo Chemical Company, Limited Tokyo 104-8260 (JP)**

(72) Inventors:
• **SADAOKA, Kazuo**
 **Toyonaka-shi**
 **Osaka 561-0802 (JP)**

• **HIROYAMA, Yuichi**
 **Tsukuba-shi**
 **Ibaraki 300-2617 (JP)**
• **SAWABE, Yoshinari**
 **Tsukuba-shi**
 **Ibaraki 300-4232 (JP)**

(74) Representative: **Hart-Davis, Jason et al**
 **Cabinet Beau de Loménie**
 **158, rue de l'Université**
 **75340 Paris Cedex 07 (FR)**

(54) **SINTERED BODY, AND THERMOELECTRIC CONVERSION MATERIAL**

(57)    Disclosed are a sintered body and a thermoelectric conversion material. The sintered body comprises a manganese-based oxide as a main component, and further comprises an oxide A wherein the oxide A represents one or more members selected from among nickel oxides, copper oxide and zinc oxide, and a metal M wherein the metal M represents one or more members selected from among Pd, Ag, Pt and Au.

EP 2 275 392 A1

**Description**

<u>TECHNICAL FIELD</u>

The present invention relates to a sintered body and a thermoelectric conversion material. More particularly, the present invention relates to a sintered body comprising a manganese-based oxide, and to a thermoelectric conversion material.

<u>BACKGROUND ART</u>

Sintered bodies comprising a manganese-based oxide are utilized in various fields such as magnetic materials, solid oxides for fuel cells and thermoelectric conversion materials.

A manganese-based oxide includes $CaMnO_3$. JP-A No. 2003-142742 (Examples) discloses to use this as a thermoelectric conversion material and specifically discloses that a $CaMnO_3$ powder is pulverized, molded and then sintered in atmospheric air at 1550°C to yield a sintered body of a manganese-based oxide.

<u>DISCLOSURE OF THE INVENTION</u>

However, the sintered body obtained above has a problem that cracks are generated in the sintered body when applying pressure such as processing thereof, that is, mechanical strength thereof is not sufficient. The present invention has an object of providing a sintered body superior in mechanical strength, as compared with sintered bodies of a conventional manganese-based oxide.

The present inventors have variously investigated and resultantly completed the present invention. That is, the present invention provides the following inventions.

<1> A sintered body comprising a manganese-based oxide as a main component, and further comprising an oxide A wherein the oxide A represents one or more members selected from among nickel oxides, copper oxide and zinc oxide, and a metal M wherein the metal M represents one or more members selected from among Pd, Ag, Pt and Au.

<2> The sintered body according to <1>, wherein the manganese-based oxide has a perovskite type crystal structure or a layered perovskite type crystal structure.

<3> The sintered body according to <1> or <2>, wherein the manganese-based oxide comprises calcium.

<4> The sintered body according to any one of <1> to <3>, wherein the ratio of the total molar amount of the metal M to one mol of the manganese-based oxide is 0.01 or more and 0.9 or less.

<5> The sintered body according to any one of <1> to <4>, wherein the oxide A is copper oxide.

<6> The sintered body according to <5>, wherein the ratio of the molar amount of the copper oxide to one mol of the manganese-based oxide is 0.0001 or more and 0.25 or less.

<7> The sintered body according to any one of <1> to <6>, wherein the metal M is Ag.

<8> A thermoelectric conversion material composed of the sintered body according to any one of <1> to <7>.

<9> A thermoelectric converting device comprising the thermoelectric conversion material according to <8>.

<10> A method for the production of a sintered body for thermoelectric conversion material, the method comprising a step of sintering, at a temperature within the range of from 800°C to 1100°C in an oxidizing atmosphere, a molded body comprising a manganese-based oxide, copper oxide and a metal M, wherein the metal M represents one or more members selected from among Pd, Ag, Pt and Au.

<u>MODE FOR CARRYING OUT THE INVENTION</u>

The sintered body of the present invention comprises a manganese-based oxide as a main component, and further comprises an oxide A wherein the oxide A represents one or more members selected from among nickel oxides, copper oxide and zinc oxide, and a metal M wherein the metal M represents one or more members selected from among Pd, Ag, Pt and Au. The manganese-based oxide means an oxide comprising manganese, and "comprising a manganese-based oxide as a main component" means that the amount of a manganese-based oxide in a sintered body is 50 mol% or more. This can be determined by powder X-ray diffractometry, composition analysis and the like of a sintered body.

The manganese-based oxide includes an oxide represented by $EMnO_3$ wherein E represents one or more elements selected from the group consisting of Ca, Sr, Ba, La, Y and lanthanoid, $Ca_{n+1}Mn_nO_{3n+1}$ wherein n represents an integer of from 1 to 10, $CaMn_7O_{12}$, $Mn_3O_4$, $MnO_2$ or $CuMnO_2$. It is preferable that the manganese-based oxide have a perovskite type crystal structure or a layered perovskite type crystal structure for further enhancing a thermoelectric converting property. It is preferable that the manganese-based oxide comprise calcium.

The manganese-based oxide having a perovskite type crystal structure specifically includes an oxide repre-

sented by $CaMnO_3$ wherein Ca and/or Mn may be partially substituted by heterogeneous elements. The heterogeneous element for partially substituting Ca includes Mg, Sr, Ba, Sc, Y, La, Ce, Pr, Nd, Sm, Eu, Gd, Tb, Dy, Ho, Er, Tm, Yb, Lu, Bi, Sn, In and Pb, and preferably Mg, Sr and Ba. These are used singly or in combination. The heterogeneous element for partially substituting Mn includes V, Ru, Nb, Mo, W and Ta. These are used singly or in combination. A thermoelectric conversion material comprising a sintered body of an oxide represented by $CaMnO_3$ in which Ca and/or Mn is partially substituted by heterogeneous elements has an improved thermoelectric converting property.

The manganese-based oxide having a layered perovskite type crystal structure specifically includes an oxide represented by the formula (1):

$$Ca_{n+1}Mn_nO_{3n+1} \qquad (1)$$

wherein n represents an integer of from 1 to 10, and Ca and/or Mn may be partially substituted by heterogeneous elements.

The heterogeneous element for partially substituting Ca in the formula (1) includes Mg, Sr, Ba, Sc, Y, La, Ce, Pr, Nd, Sm, Eu, Gd, Tb, Dy, Ho, Er, Tm, Yb, Lu, Bi, Sn, In and Pb, and preferably Mg, Sr and Ba. These are used singly or in combination. The heterogeneous element for partially substituting Mn includes V, Ru, Nb, Mo, W and Ta. These are used singly or in combination. A thermoelectric conversion material comprising a sintered body of an oxide represented by the formula (1) in which Ca and/or Mn is partially substituted by heterogeneous elements has an improved thermoelectric converting property.

The sintered body comprises an oxide A wherein the oxide A represents one or more members selected from among nickel oxides, copper oxide and zinc oxide. The oxide A is preferably copper oxide. By using copper oxide as the oxide A, the sintering temperature in producing a sintered body can be further lowered, and a thermoelectric conversion material having an improved thermoelectric converting property is obtained. When the oxide A is copper oxide, the ratio of the molar amount of the copper oxide to one mol of a manganese-based oxide comprised in a sintered body is preferably 0.0001 or more and 0.25 or less, more preferably 0.01 or more and 0.05 or less.

The sintered body comprises a metal M wherein the metal M represents one or more members selected from among Pd, Ag, Pt and Au). The metal M is comprised as a single metal or alloy. The metal M preferably comprises Ag, and it is more preferable that the metal M is Ag. The ratio of the total molar amount of the metal M to one mol of a manganese-based oxide comprised in a sintered body is preferably 0.01 or more and 0.9 or less, more preferably 0.01 or more and 0.6 or less.

The average of the size of particles (grains) constituting a sintered body is usually 3 $\mu$m or less, whereby the mechanical strength of a sintered body can be further enhanced. The smaller average of the size of the particles is more preferable. The size of particles constituting a sintered body can be determined by observing the surface of a sintered body with a scanning electron microscope (SEM). Specifically, observation of a reflected electron image with a scanning electron microscope (SEM) is performed on the surface obtained by mirror-polishing of an arbitrary surface of a sintered body, 100 particles constituting a sintered body are arbitrarily picked out of the resultant observed image, and the area and the equivalent circle diameter corresponding to the area of each of the 100 particles are measured with an image treatment means, and the average thereof is calculated, thus, the average of the size of particles constituting a sintered body can be determined.

It is preferable that the metal M is in the form of particles in a sintered body. The average of the size of particles of the metal M constituting a sintered body is usually 1 $\mu$m or less, whereby a thermoelectric converting property can be further enhanced in the case of use as a thermoelectric conversion material. The smaller average of the size of the metal M is more preferable. The size of particles of the metal M can be determined by using an energy dispersion type X-ray analyzer (EDX) and a scanning electron microscope (SEM) for the surface of a sintered body. Specifically, identification of particles of the metal M with an energy dispersion type X-ray analyzer (EDX) is performed on the surface obtained by mirror-polishing of an arbitrary surface of a sintered body, thereafter, observation of a reflected electron image with a scanning electron microscope (SEM) is performed on the same field of view, and 50 particles of the metal M constituting a sintered body are arbitrarily picked out of the resultant observed image, and the area and the equivalent circle diameter corresponding to the area of each of the 50 particles are measured with an image treatment means, and the average thereof is calculated, thus, the average of the size of particles of the metal M can be determined.

The relative density of a sintered body is preferably 80% or more, more preferably 90% or more. The sintered body can be used in a shape suitable for each application, such as plate, circular cylinder, and rectangular cylinder. The relative density is determined by the following formula where the formula weight of a manganese-based oxide in a sintered body is represented by $\alpha_1$, the theoretical density of a manganese-based oxide is represented by $\beta_1$ (g/cm$^3$). the atomic weight of a metal M is represented by $\alpha_2$, the theoretical density of a metal M is represented by $\beta_2$ (g/cm$^2$), the formula weight of an oxide A is represented by $\alpha_3$, the theoretical density of an oxide A is represented by $\beta_3$ (g/cm$^3$), the actually measured density of a sintered body is represented by $\gamma$ (g/cm$^3$), the ratio of a metal M in a sintered body is represented by x (mol%) and the ratio of an oxide A in a sintered body is represented by y (mol%):

$$\text{Relative density (\%)} = \gamma/[\{\alpha_1 \times (100-x-y) + \alpha_2 \times x + \alpha_3 \times y\} /$$

$$\{\alpha_1 \times (100-x-y)/\beta_1 + \alpha_2 \times x/\beta_2 + \alpha_3 \times y/\beta_3\}] \times 100.$$

Next, a method of producing a sintered body will be described.

A sintered body can be produced by sintering a molded body comprising a manganese-based oxide, an oxide A wherein the oxide A has the same meaning as described above, and a metal M wherein the metal M has the same meaning as described above. By use of this molded body, the uniformity of the composition of a sintered body and the uniformity of the structure of a sintered body can be improved and the deformation of a sintered body can be suppressed, thus, the mechanical strength of a sintered body can be further improved. When the oxide A is copper oxide, sintering is preferably carried out at a temperature within the range of from 800°C to 1100°C in an oxidizing atmosphere, whereby a sintered body which is particularly suitable for a thermoelectric conversion material can be obtained. This atmosphere includes an air atmosphere or an atmosphere comprising 20 vol% or more of oxygen. The atmosphere comprising 20 vol% or more of oxygen includes an oxygen atmosphere, and a mixed gas atmosphere of oxygen-inert gas (oxygen-nitrogen, oxygen-argon, etc.).

Sintering may be carried out under normal pressure, and pressure sintering using hot press or pulse current sintering may also be carried out. As the sintering atmosphere, an inert atmosphere may also be substituted for the above-described oxidizing atmosphere. The inert atmosphere includes atmospheres composed of an inert gas such as nitrogen and argon. The inert atmosphere may comprise oxygen in an approximate amount not generating an oxidizing atmosphere (for example, the oxygen concentration is less than about 20 vol%). It is also possible, after sintering in such an inert atmosphere, to perform annealing in an oxidizing atmosphere, thereby controlling the oxygen amount in a sintered body. Moreover, the resultant sintered body may be pulverized, and sintering may be carried out again using the pulverized substance.

The above-described molded body can be obtained, for example, by any of the following methods (a) to (f).

(a) A manganese-based oxide, an oxide A and a metal M are mixed, and then molded to yield a molded body.
(b) A manganese-based oxide, an oxide A and a raw material of a metal M are mixed, then calcined, and molded to yield a molded body.
(c) A raw material of a manganese-based oxide, an oxide A and a metal M are mixed, then calcined, and molded to yield a molded body.
(d) A raw material of a manganese-based oxide, an oxide A and a raw material of a metal M are mixed, then calcined, and molded to yield a molded body.
(e) A raw material of a manganese-based oxide and an oxide A are mixed, then calcined, further, the calcined product and a metal M are mixed, and molded to yield a molded body.
(f) A raw material of a manganese-based oxide and an oxide A are mixed, then calcined, further, the calcined product and a raw material of a metal M are mixed, and calcined and molded to yield a molded body.

The manganese-based oxide can be obtained by calcining a raw material of a manganese-based oxide. The raw material of a manganese-based oxide can be obtained usually by weighing compounds comprising metal elements constituting a manganese-based oxide so as to give a prescribed composition, and mixing them. In the above-described cases (c) to (f), other materials (specifically, an oxide A, a metal A, a raw material of a metal M) may also be mixed in the above-described mixing, before performing calcination.

As the compound comprising metal elements constituting a manganese-based oxide, for example, an oxide is used, alternatively, a compound capable of becoming a oxide when decomposed and/or oxidized at high temperatures, such as a hydroxide, a carbonate, a nitrate, a halide, a sulfate, and an organic acid salt is used. Instead of the compound, a metal comprising the above-described metal elements may be used singly. In the case of use of $CaMnO_3$ as the manganese-based oxide, constituent metal elements are Ca and Mn, and the compound comprising Ca includes a carbonate, a sulfate, a hydroxide and the like, and a carbonate is preferably used. The compound comprising Mn includes manganese monoxide, manganese dioxide, dimanganese trioxide, trimanganese tetraoxide, manganese nitrate, manganese acetate and the like, and manganese dioxide is preferably used. The raw material of a manganese-based oxide can be obtained by weighing these compounds so as to give a prescribed composition, and mixing them.

The metal M includes one or more metal single bodies selected from among Pd, Ag, Pt and Au, or an alloy thereof. The metal M can also be obtained by decomposition of a raw material of a metal M in calcination. The raw material of a metal M includes an oxide, a nitrate, an acetate, a sulfate, a halide, an amine complex, an organic metal compound and the like. For example, when the metal M is Ag, the raw material of a metal M includes $Ag_2O$, $AgNO_3$ and the like.

The oxide A includes one or more members selected from among nickel oxides, copper oxide and zinc oxide. Instead of the oxide A, a raw material of an oxide A, that is, a compound which is capable of becoming an oxide A in calcination can also be used. The raw material of an oxide A includes a nitrate, an acetate, a sulfate, a halide, an amine complex, an organic metal compound and the like. For example, when the oxide A is copper oxide, the raw material of the oxide A includes $Cu(NO_3)_2$, $CuSO_4$ and the like.

Mixing may be carried out by either a dry mixing method or a wet mixing method, and a method capable of uniformly mixing compounds comprising metal elements is preferably carried out, and in this case, examples of the mixing apparatus include apparatuses such as a ball mill, a V-shaped mixer, a vibration mill, an attritor, a dino mill and a dynamic mill. A manganese-based oxide or a raw material of a manganese-based oxide can be obtained also by a co-precipitation method, a hydrothermal method, a dry up method of evaporating an aqueous solution to dryness, a sol gel method and the like, in addition to the above-described mixing.

The above-described molding may be performed so as to give an intended shape such as a plate shape, a rectangular cylinder shape and a circular cylinder shape. The molding method can be carried out, for example, by a uniaxial press, a cold isostatic press (CIP), a mechanical press, a hot press and a hot isostatic press (HIP). The molded body may comprise a binder, a dispersant, a releasing agent and the like.

The above-described calcination is preferably carried out at a temperature lower than the sintering temperature. The calcination is preferably carried out in an oxidizing atmosphere as described above. When the calcined substance comprises a raw material of a metal M, the calcination atmosphere is preferably an inert atmosphere or a reducing atmosphere. After calcination, calcination may be carried out again in an oxidizing atmosphere, alternatively, in sintering to be carried out after calcination, the oxygen concentration in its atmosphere may be controlled. Further, pulverization may be carried out after calcination.

Calcination conditions such as a calcining temperature, a calcining atmosphere, a calcining temperature retention time and temperature rising and falling speeds in calcination and sintering conditions such as a sintering temperature, a sintering atmosphere, a sintering temperature retention time and temperature rising and falling speeds in sintering may be appropriately set depending on the kind of a manganese-based oxide, an oxide A and a metal M. For reducing the size of particles constituting a sintered body and the size of particle of a metal M, it is preferable to set a low sintering temperature and a short sintering temperature retention time, within a range capable of producing a sintered body. Each of a manganese-based oxide, a raw material of a manganese-based oxide, an oxide A, a metal M, a raw material of a metal M is preferably in the form of particles, and powder properties (average particle diameter, specific surface area) may be appropriately set. In a sintered body, the relative density and the average of the size of constituent particles are adjusted by powder properties of a calcined substance and a molded substance, a molding pressure in molding, a sintering temperature, a sintering temperature retention time and the like, in addition to the above-described powder properties.

Among (a) to (f), preferable are (c) to (f) from the standpoint of further reducing the size of particles constituting a sintered body. Further, (e) or (f) is preferable from the standpoint of further reducing the size of particles of a metal M.

Next, sintered bodies in which the combination of a manganese-based oxide/a metal M/an oxide A is a manganese-based oxide having a perovskite type crystal structure or a layered perovskite type crystal structure/Ag/copper oxide are exemplified, and particularly when the manganese-based oxide is $CaMnO_3$, its production method will be described.

A sintered body in which the combination of a manganese-based oxide/a metal M/copper oxide is $CaMnO_3$/Ag/CuO can be produced by molding a mixture of $CaMnO_3$, Ag and CuO to obtain a molded body (corresponding to the above-described case (a)), and then sintering the molded body by heating up to a sintering temperature within the range of from 800°C to 1100°C. The sintering temperature retention time is 0 to 48 hours. When the sintering temperature is lower than 800°C, it is difficult for the molded body to be sintered in some cases, and when the sintering temperature is over 1100°C, a sintered body is not formed easily to elution of CuO. The sintering temperature is preferably a temperature within the range or from 900°C to 1100°C, further preferably from 950°C to 1100°C. The sintering atmosphere is preferably an oxidizing atmosphere. It is also possible to control the oxygen amount in a manganese-based oxide of a sintered body, by changing the oxygen concentration. It may also be permissible, after sintering in an inert atmosphere, to control the oxygen amount of a sintered body by performing annealing in an oxidizing atmosphere.

A mixture of $CaMnO_3$, Ag and CuO may also be produced by calcining a mixture of a raw material of $CaMnO_3$ which is capable of becoming $CaMnO_3$ by calcination, a raw material of Ag which is capable of becoming Ag by calcination, and CuO (corresponding to the above-described case (d)). The calcination may be carried out by keeping at a calcining temperature of from 600°C to 1100°C for 0 to 24 hours.

A mixture of $CaMnO_3$, Ag and CuO may also be produced by calcining a mixture of CuO and a raw material of $CaMnO_3$ to obtain a mixture of $CaMnO_3$ and CuO, and then mixing Ag (corresponding to the above-described case (e)). A mixture of $CaMnO_3$, Ag and CuO may also be produced by mixing a raw material of Ag with a mixture of $CaMnO_3$ and CuO, and calcining the resultant mixture (corresponding to the above-described case (f)). According to these methods, an Ag particle in the mixture is easily made finer.

The sintered body obtained as described above is superior in mechanical strength, and further, superior also in thermal shock resistance. Since its thermoelectric converting property as a thermoelectric conversion material is not deteriorated, a thermoelectric conversion material composed of this sintered body is very useful for a thermoelectric converting device. For a thermoelectric converting device, conventional techniques as disclosed in, for example, JP-A No. 5-315657 may be used. In a thermoelectric converting device, a p-type thermoelectric conversion material and an n-type thermoelectric conversion material may be used in combination, and it may also be permissible that a thermoelectric conversion material of the present invention is used in any one of a p-type thermoelectric conversion material and an n-type thermoelectric conversion material and conventional techniques are used in another material.

The efficiency of converting thermal energy into electric energy of a thermoelectric conversion material (hereinafter, referred to as "energy conversion efficiency" in some cases) depends on the performance index (Z) of a thermoelectric conversion material. The performance index (Z) is determined according to the following formula (2) using the Seebeck coefficient ($\alpha$), the electric conductivity ($\sigma$) and the thermal conductivity ($\kappa$) of a thermoelectric conversion material. A thermoelectric conversion material having larger performance index (Z) is said to be a thermoelectric converting device superior in energy conversion efficiency. Particularly, $\alpha^2 \times \sigma$ in the formula (2) is called power factor (PF). A thermoelectric conversion material having larger PF value is said to be a thermoelectric converting device superior in output per unit temperature.

$$Z = \alpha^2 \times \sigma / \kappa \qquad (2)$$

Here, the unit of Z is 1/K, the unit of $\alpha$ is V/K, the unit of $\sigma$ is S/m and the unit of $\kappa$ is W/(m•K).

<u>EXAMPLES</u>

The present invention will be illustrated further in detail by examples below. For evaluation of the structure of a sintered body, the contact resistance and properties as a thermoelectric conversion material, methods shown below were used.

1. Structure analysis

The crystal structure of sintered body specimens was analyzed by a powder X-ray diffraction method using a CuK$\alpha$ radiation source, using an X-ray diffractometer RINT2500TTR type manufactured by Rigaku Corporation.

2. Contact Resistance

A sintered body specimen was processed into a rectangular cylinder shape, a platinum line was bonded thereto with a silver paste, and then the resistance value ($R_A(\Omega)$) by a direct current four-terminal method and the resistance value ($R_B(\Omega)$) by a direct current two-terminal method were measured, and the contact resistance ($\Omega \cdot mm^2$) was determined according to the following formula. In the formula, $R_C$ represents a resistance value (Q) of the measurement system, and X represents a cross-sectional area ($mm^2$) of a sintered body specimen.

$$\text{Contact resistance} = (R_B - R_A - R_C) \times X / 2$$

3. Thermoelectric converting properties

Electric conductivity ($\sigma$)

A sintered body specimen was processed into a rectangular cylinder shape, a platinum line was bonded thereto with a silver paste, and then the electric conductivity ($\sigma$) was measured by a direct current four-terminal method. The measurement was carried out while changing the temperature in the range from room temperature to 1073 K in a nitrogen gas flow. The unit of $\sigma$ was S/m.

Seebeck coefficient ($\alpha$)

An R-type thermocouple (composed of platinum-rhodium line and platinum line) was, with a silver paste, bonded on the both end surfaces of a sintered body specimen processed into the same shape as in measurement of electric conductivity, and the temperatures of the both end surfaces of the sintered body specimen and thermoelectromotive forces were measured. The measurement was carried out while changing the temperature in the range from room temperature to 1073 K in a nitrogen gas flow. A glass tube in which air was flowing was allowed to make a contact with the one end surface of the sintered body specimen to make a low temperature part, the temperatures of the both end surfaces of the sintered body specimen were measured by the R-type thermocouple, and simultaneously, the thermo-electromotive force ($\Delta V$) generated between the both end surfaces of the sintered body specimen was measured by a platinum line of the R-type thermocouple. The temperature difference ($\Delta T$) between the both ends of the sintered body specimen was controlled in the range of 1 to 10°C by controlling the flow rate of air flowing in the glass tube, and the Seebeck coefficient ($\alpha$) was determined from the inclinations of $\Delta T$ and $\Delta V$. The unit of $\alpha$ was V/K.

Power factor (PF)

The value of PF was determined according to the following formula from the above-described values of $\sigma$, $\alpha$.

$$PF = \alpha^2 \times \sigma$$

Here, the unit of PF is W/(m·K$^2$), the unit of $\alpha$ is V/K, and the unit of $\sigma$ is S/m.

Comparative Example 1 (manganese-based oxide only)

$CaCO_3$ (manufactured by Ube Material Industries, CS3N-A (trade name)) of 8.577 g, $MnO_2$ (manufactured by Kojundo Chemical Laboratory) of 7.852 g and $MoO_3$ (manufactured by Kojundo Chemical Laboratory) of 0.247 g were weighed out, then mixed for 20 hours by a wet ball mill using zirconia balls, and calcined by keeping at 900°C for 10 hours in air. The resultant calcined substance was pulverized for 20 hours by a wet ball mill using zirconia balls, and then molded into a rod shape by a uniaxial press (molding pressure: 500 kg/cm$^2$). The resultant molded body was sintered by keeping at 1300°C for 10 hours in air to yield Sintered body 1. Powder X-ray diffractometry revealed that Sintered body 1 had the same crystal structure as a perovskite type crystal of $CaMnO_3$. Sintered body 1 was cut, then polished, and observed visually. A lot of cracks were confirmed on the polished surface. Sintered body 1 was poor in mechanical strength, and was fractured easily.

Reference Example 1 (manganese-based oxide + copper oxide)

A molded body was fabricated in the same manner as in Comparative Example 1 excepting that $CaCO_3$ (manufactured by Ube Material Industries, CS3N-A (trade name)) of 8.577 g, $MnO_2$ (manufactured by Kojundo Chemical Laboratory) of 7.852 g, $MoO_3$ (manufactured by Kojundo Chemical Laboratory) of 0.247 g and CuO (manufactured by Kojundo Chemical Laboratory) of 4.545 g were used. The resultant molded body was sintered by keeping at 1050°C for 10 hours in air to yield Sintered body 2. Powder X-ray diffractometry revealed that Sintered body 2 had the same crystal structure as a perovskite type crystal of $CaMnO_3$ and a crystal structure of CuO. This could conform that CuO and a manganese-based oxide did not react easily in Sintered Body 2.

Example 1 (manganese-based oxide + copper oxide + Ag)

$CaCO_3$ (manufactured by Ube Material Industries, CS3N-A (trade name)) of 8.577 g, $MnO_2$ (manufactured by Kojundo Chemical Laboratory) of 7.852 g, $MoO_3$ (manufactured by Kojundo Chemical Laboratory) of 0.247 g, CuO (manufactured by Kojundo Chemical Laboratory) of 0.359 g (the ratio of the molar amount of the copper oxide to one mol of a manganese-based oxide is 0.05) and $Ag_2O$ (manufactured by Kojundo Chemical Laboratory) of 2.614 g (the ratio of the total molar amount of a metal M to one mol of a manganese-based oxide is 0.26) were weighed out, then mixed for 20 hours by a wet ball mill using zirconia balls, and calcined by keeping at 900°C for 10 hours in air. The resultant mixture of a manganese-based oxide, copper oxide and Ag was pulverized for 20 hours by a wet ball mill using zirconia balls, and then molded into a rod shape by a uniaxial press (molding pressure: 500 kg/cm$^2$ The resultant molded body was sintered by keeping at 1050°C for 10 hours in air to yield Sintered body 3.

Powder X-ray diffractometry of Sintered body 3 revealed detection of a peak of the same crystal structure as a perovskite type crystal of $CaMnO_3$ and a peak of a crystal structure of Ag. In powder X-ray diffractometry of Sintered body 3, the crystal structure of CuO could not be confirmed. This is ascribable to small amount of CuO, and the results of Reference Example 1 indicate the presence of CuO also in Sintered body 3. Based on these facts, the main component of Sintered body 3 was found to be a manganese-based oxide. Sintered body 3 was cut, then polished, and observed visually. No cracks were confirmed on the polished surface. Sintered body 3 was superior in mechanical strength. Sintered body 3 had a relative density of 90% or more, and a contact resistance ($\Omega \cdot mm^2$) at 873 K of as low as 64 when that of Sintered body 1 was 100. The thermoelectric converting property was approximately the same as that of Sintered body 1.

Example 2 (manganese-based oxide + copper oxide + Ag)

Sintered body 4 was fabricated in the same manner as in Example 1 excepting that the amount of $Ag_2O$ was changed to 3.484 g (the ratio of the total molar amount of a metal M to one mol of a manganese-based oxide is 0.34). Powder X-ray diffractometry of Sintered body 4 revealed detection of a peak of the same crystal structure as a perovskite type crystal of $CaMnO_3$ and a peak of a crystal structure of Ag. In powder X-ray diffractometry of Sintered body 4, the crystal structure of CuO could not be confirmed. This is ascribable to small amount of CuO, and the results of Reference Example 1 indicate the presence of CuO also in Sintered body 4. Based on these facts, the main component of Sintered body 4 was found to be a manganese-based oxide. Sintered body 4 was cut, then polished, and observed visually. No cracks were confirmed on the polished surface. Sintered body 4 was superior in mechanical strength. Sintered body 4 had a relative density of 90% or more, and a contact resistance ($\Omega \cdot mm^2$) at 873 K of as lower as 43 when that of Sintered body 1 was 100. The thermoelectric converting property was approximately the same as that of Sintered body 1.

Example 3 (manganese-based oxide + copper oxide + Ag)

Sintered body 5 was fabricated in the same manner as in Example 1 excepting that the amount of $Ag_2O$ was changed to 4.482 g (the ratio of the total molar amount of a metal M to one mol of a manganese-based oxide is 0.44). Powder X-ray diffractometry of Sintered body 5 revealed detection of a peak of the same crystal structure as a perovskite type crystal of $CaMnO_3$ and a peak of a crystal structure of Ag. In powder X-ray diffractometry of Sintered body 5, the crystal structure of CuO could not be confirmed. This is ascribable to small amount of CuO, and the results of Reference Example 1 indicate the presence of CuO also in Sintered body 5. Based on these facts, the main component of Sintered body 5 was found to be a manganese-based oxide. Sintered body 5 was cut, then polished, and observed visually. No cracks were confirmed on the polished surface. Sintered body 5 was superior in mechanical strength. Sintered body 5 had a relative density of 90% or more, and a contact resistance ($\Omega \cdot mm^2$) at 873 K of as further lower as 21 when that of Sintered body 1 was 100. The thermoelectric converting property was approximately the same as that of Sintered body 1.

Comparative Example 2 (manganese-based oxide + Ag)

A molded body was fabricated in the same manner as in Example 1 excepting that CuO was not used. The resultant molded body was sintered by keeping at 1300°C for 10 hours in air to yield Sintered body 6. Powder X-ray diffractometry of Sintered body 6 revealed detection of a peak of the same crystal structure as a perovskite type crystal of $CaMnO_3$ and a peak of a crystal structure of Ag. Sintered body 6 was cut, then polished, and observed visually. A lot of cracks were confirmed on the polished surface. Sintered body 6 was poor in mechanical strength, and was fractured easily.

Comparative Example 3 (manganese-based oxide + Ag)

A molded body was fabricated in the same manner as in Example 1 excepting that CuO was not used. The resultant molded body was sintered by keeping at 1200°C for 10 hours in air to yield Sintered body 7. Powder X-ray diffractometry of Sintered body 7 revealed detection of a peak of the same crystal structure as a perovskite type crystal of $CaMnO_3$ and a peak of a crystal structure of Ag. Sintered body 7 was cut, then polished, and observed visually. A lot of cracks were confirmed on the polished surface. Sintered body 7 was poor in mechanical strength, and was fractured easily.

INDUSTRIAL APPLICABILITY

According to the present invention, a sintered body superior in mechanical strength as compared with conventional manganese-based oxide sintered bodies can be provided. When a sintered body is made a contact with (or joined to) a metal of an electrode or the like, the contact resistance between sintered body-metal is small. The sintered body is superior also in thermal shock resistance, and as a thermoelectric conversion material, its thermoelectric converting property is not deteriorated as compared with conventional materials, further, the contact property with an electrode is also superior as described above, thus, it is extremely suitable for a thermoelectric converting device, and a thermoelectric converting device comprising a thermoelectric conversion material composed of this sintered body can be suitably used for thermoelectric converting electric generation utilizing waste heat of factories, waste heat of incinerators, waste heat of factory furnaces, waste heat of automobiles, underground heat, solar heat and the like, and can also be used for precise temperature controlling apparatuses for laser diodes and the like, air conditioning equipments, refrigerators and the like. The sintered body of the present invention can be used also for solid oxides for fuel cells, magnetic materials, and the like, in addition to thermoelectric conversion materials.

**Claims**

1. A sintered body comprising a manganese-based oxide as a main component, and further comprising an oxide A wherein the oxide A represents one or more members selected from among nickel oxides, copper oxide and zinc oxide, and a metal M wherein the metal M represents one or more members selected from among Pd, Ag, Pt and Au.

2. The sintered body according to Claim 1, wherein the manganese-based oxide has a perovskite type crystal structure or a layered perovskite type crystal structure.

3. The sintered body according to Claim 1 or 2, wherein the manganese-based oxide comprises calcium.

4. The sintered body according to any one of Claims 1 to 3, wherein the ratio of the total molar amount of the metal M to one mol of the manganese-based oxide is 0.01 or more and 0.9 or less.

5. The sintered body according to any one of Claims 1 to 4, wherein the oxide A is copper oxide.

6. The sintered body according to Claim 5, wherein the ratio of the molar amount of the copper oxide to one mol of the manganese-based oxide is 0.0001 or more and 0.25 or less.

7. The sintered body according to any one of Claims 1 to 6, wherein the metal M is Ag.

8. A thermoelectric conversion material composed of the sintered body according to any one of Claims 1 to 7.

9. A thermoelectric converting device comprising the thermoelectric conversion material according to Claim 8.

10. A method for the production of a sintered body for thermoelectric conversion material, the method comprising a step of sintering, at a temperature within the range of from 800°C to 1100°C in an oxidizing atmosphere, a molded body comprising a manganese-based oxide, copper oxide and a metal M, wherein the metal M represents one or more members selected from among Pd, Ag, Pt and Au.

| | INTERNATIONAL SEARCH REPORT | International application No. |
|---|---|---|
| | | PCT/JP2009/057543 |

A. CLASSIFICATION OF SUBJECT MATTER
*C04B35/00*(2006.01)i, *H01L35/22*(2006.01)i, *H01L35/34*(2006.01)i

According to International Patent Classification (IPC) or to both national classification and IPC

B. FIELDS SEARCHED

Minimum documentation searched (classification system followed by classification symbols)
C04B35/00-35/22, H01L35/22-37/04, H05B1/00-3/00

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | WO 2006/027892 A1  (Murata Mfg. Co., Ltd.),<br>16 March, 2006 (16.03.06),<br>Claims 1, 2; Par. Nos. [0011], [0026], [0065]<br>to [0067]; sample No. 303 on the table 15<br>& US 2007/0138918 A1   & DE 112005002067 T | 10<br>1-9 |
| A | JP 2001-143907 A  (Denso Corp.),<br>25 May, 2001 (25.05.01),<br>Claims 1, 3, 4<br>& US 2002/0020949 A1   & EP 1137016 A1<br>& WO 2001/016966 A1 | 1-10 |
| A | JP 2002-121071 A  (Murata Mfg. Co., Ltd.),<br>23 April, 2002 (23.04.02),<br>Claims 1, 2<br>& US 2002/0074657 A1   & DE 10150248 A | 1-10 |

| ☒ Further documents are listed in the continuation of Box C. | ☐ See patent family annex. |
|---|---|

* Special categories of cited documents:
"A" document defining the general state of the art which is not considered   to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>20 May, 2009 (20.05.09) | Date of mailing of the international search report<br>02 June, 2009 (02.06.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| | International application No. |
|---|---|
| | PCT/JP2009/057543 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 10-139542 A  (TDK Corp.),<br>26 May, 1998 (26.05.98),<br>Claim 1<br>(Family: none) | 1-10 |
| A | JP 11-335163 A  (Matsushita Electric Industrial Co., Ltd.),<br>07 December, 1999 (07.12.99),<br>Claim 1<br>(Family: none) | 1-10 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003142742 A
- JP 5315657 A